(19) Europäisches Patentamt

European Patent Office

Office européen des brevets

(11) **EP 4 718 750 A1**

(12) **EUROPEAN PATENT APPLICATION**

(43) Date of publication:
01.04.2026 Bulletin 2026/14

(21) Application number: 24203205.0

(22) Date of filing: 27.09.2024

(51) International Patent Classification (IPC):
*H04B 17/10* (2015.01)

(52) Cooperative Patent Classification (CPC):
**H04B 17/104; H04B 17/0085;** G01R 23/00

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **National Instruments Corporation
Austin, Texas 78759 (US)**

(72) Inventor: **VERBEYST, Frans
1785 Merchtem (BE)**

(74) Representative: **Winger
Mouterij 16 bus 101
3190 Boortmeerbeek (BE)**

(54) **METHOD FOR EVALUATING A MULTI-CHANNEL SIGNAL GENERATOR**

(57) The proposed method for performance assessment of a multichannel signal generator comprising a plurality of transmit channels comprises:
- conveying to the multichannel signal generator configuration information,
- determining for each tone an amplitude and phase,
- distributing the tones over the transmit channels,
- generating, based on the configuration information, in each transmit channel a periodic modulated signal comprising the tones distributed to the respective transmit channel,
- combining the generated periodic modulated signals in a combined signal,
wherein the amplitudes and phases are determined so that the combined signal has a crest factor below a given threshold level. The method further comprises :
- measuring the combined signal, taking into account the configuration information,
- aligning the combined signal relative to a reference combined signal and extracting individual tones corresponding to the tones generated in the respective transmit channels,
- determining a relative delay and/or a phase offset for at least two transmit channels by comparing the extracted individual tones with corresponding individual tones extracted from said reference combined signal, so that information can be obtained on a difference in relative delay and/or phase offset between said at least two transmit channels.

Fig.1

**Description**

**Field of the invention**

The present invention is generally related to the field of vector signal generators and measurement systems for assessing the performance of such vector signal generators in a multichannel configuration.

**Background of the invention**

Multichannel phase-coherent systems are essential to several applications, such as Active Electronically Scanned Arrays for Radar, electronic warfare, Global Navigation Satellite Systems (GNSS) and 5G networks. They are typically used for performing tasks like beam steering, multipath signal propagation, channel emulation, channel parameter estimation, radar target emulation and antenna array testing.

For successful beam shaping and scanning in array systems, it is essential to precisely set the amplitude and phase differences between the element channels. Therefore, it is key to extract performance parameters such as relative delay and phase offset as accurately as possible. Existing state-of-the-art solutions typically exploit phase unwrapping techniques to achieve this.

Phase unwrapping applies a frequency-by-frequency approach to deal with the fact that phase values are wrapped between -180° and +180° (a phase is known modulo 360 degrees) while in order to estimate the delay (and phase offset) the slope and offset of a line needs to be fitted as function of frequency. Because the unwrapping is performed frequency by frequency, the approach is sensitive to spurious signals which coincide with one or more of the frequencies, as this may result in incorrect phase unwrapping.

In US9432133 B2 multichannel signal generator performance characterization employs orthogonal modulation to characterize a relative performance of channels of the multichannel signal generator. In a first and a second channel of the multichannel signal generator a first and a second signal including an orthogonal frequency-division multiplexing (OFDM) digital modulation have a first set of subcarriers assigned to the first signal and a second set of subcarriers assigned to the second signal, respectively. The proposed method for performance characterization further comprises combining the first signal and the second signal to produce a combined signal along with receiving and demodulating the combined signal according to the OFDM digital modulation using a digital receiver and determining a performance parameter of the second channel relative to the first channel from the received and demodulated combined signal.

Hence, there is a need for an approach wherein performance parameters can be estimated in a more robust and precise way.

**Summary of the invention**

It is an object of embodiments of the present invention to provide for a method wherein the performance of a multichannel signal generator having a number of transmit channels can be evaluated with increased precision.

The above objective is accomplished by the solution according to the present invention.

In a first aspect the invention relates to a method for performance assessment of a multichannel signal generator comprising a plurality of transmit channels. The method comprises:

- conveying to the multichannel signal generator configuration information comprising at least a carrier frequency, a modulation frequency and a number of tones to be generated,
- determining for each of the tones to be generated an amplitude and phase,
- distributing the tones with the determined amplitude and phase over the transmit channels of the plurality of transmit channels,
- generating, in response to receiving a generation trigger signal and based on the configuration information, in each transmit channel a periodic modulated signal comprising the tones assigned to the respective transmit channel,
- combining the generated periodic modulated signals in a combined signal,

wherein the amplitudes and phases are determined so that the combined signal has a crest factor or peak-to-average power ratio below a given threshold level. The method further comprises :

- measuring the combined signal in response to receiving a measurement trigger signal, thereby taking into account the configuration information,
- aligning the combined signal relative to a reference combined signal,
- extracting from the aligned combined signal individual tones corresponding to the tones generated in the respective transmit channels,

- determining a relative delay and/or a phase offset for at least two transmit channels by comparing the extracted individual tones with corresponding individual tones extracted from the reference combined signal, and
- obtaining information on a difference in relative delay and/or phase offset between the at least two transmit channels based on the relative delay and/or the phase offset for the at least two transmit channels as determined.

The proposed solution indeed allows for obtaining information related to relative delay and/or phase offset with enhanced accuracy. By making sure that the combined signal of all generated modulation tones has a crest factor or peak-to-average power ratio below a given threshold level, one can reduce the uncertainty of the estimated performance parameters or even minimize this uncertainty. In the prior art solutions this impact of the crest factor of the combined signal was not at all recognized. Having a combined signal with reduced crest factor is advantageous in that it allows avoiding distortion of the measured signal due to, e.g., clipping. The combined signal can so be measured with a high signal-to-noise ratio (SNR). The proposed method not only allows monitoring a difference related to relative time delay and relative carrier phase offset, but also, for example, relative amplitude and phase distortion, without being limited thereto, between at least two transmit channels.

In a preferred embodiment the method comprises performing a reference measurement to measure the reference combined signal and to determine the input reference level from the measured reference combined signal. It is advantageous to have an input reference combined level as low as possible, so that combined with the combined signal with low crest factor clipping of the measured signal is avoided. The noise floor typically scales with the input reference level.

Preferably the reference combined signal corresponds to a full-scale range corresponding to the input reference level.

Preferably the carrier frequency is not used for carrying a generated tone.

In advantageous embodiments the tones are sets of two-tones. In other embodiments the tones are sets of more than two tones.

In some embodiments one or more of the generated tones are set to zero.

In some embodiments the generated tones have an equal amplitude.

In one embodiment the amplitudes and phases are determined so that a minimum value is obtained for the crest factor or peak-to-average power ratio of the combined signal.

Advantageously, the crest factor or peak-to-average power ratio is obtained by applying a nonlinear optimization algorithm.

In another aspect the invention relates to a system for assessing performance of a multichannel signal generator comprising

- a multichannel signal generator comprising a plurality of transmit channels,
- a processor unit/controller adapted for conveying to the multichannel signal generator configuration information comprising at least a carrier frequency, a modulation frequency and a number of tones to be generated, for determining for each of the tones to be generated an amplitude and phase, and for distributing the tones having the determined amplitude and phase over the plurality of transmit channels,

whereby the multichannel signal generator is arranged for generating, on receiving a generation trigger signal from the processing/control unit and based on the configuration information, in each transmit channel a periodic modulated signal comprising the tones assigned to the respective transmit channel, said carrier frequency not being used for carrying a generated tone.

The system further comprises

- a combiner configured to combine the generated periodic modulated signals in a combined signal,
- a signal analyzer for measuring the combined signal in response to receiving a measurement trigger signal from the processor unit/controller, thereby taking into account the configuration information,

wherein the processor unit/controller is configured to determine the amplitudes and phases so that the combined signal has a crest factor or peak-to-average power ratio below a given threshold level and to align the combined signal with a reference combined signal, to extract from the aligned combined signal individual tones corresponding to the tones generated in the respective transmit channels, and to derive information related to relative delay and/or phase offset for at least two transmit channels by comparing the extracted individual tones with corresponding individual tones extracted from said reference combined signal, so that information can be obtained on a difference in relative delay and/or phase offset between said at least two transmit channels.

In a preferred embodiment the combiner is a power combiner. The combiner is preferably substantially symmetrical.

In another embodiment the multichannel signal generator comprises a plurality of vector signal generators. In some of these embodiments the vector signal generators are arranged to receive a common local oscillator signal.

In one embodiment the multichannel signal generator is connected to the combiner via cables of substantially equal length.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

## Brief description of the drawings

The invention will now be described further, by way of example, with reference to the accompanying drawings, wherein like reference numerals refer to like elements in the various figures.

Fig.1 illustrates a system comprising a multichannel signal generator, a processing/control unit, a combiner and a signal analyzer.

Fig.2 illustrates an example of a modulation tone distribution for a four-channel signal generator. This figure also shows the use of two-tone signals. Note that in this figure $N_C$ refers to the number of channels and that the situation for channel 3 is not shown.

## Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

In a first aspect the present invention offers a method for assessing the performance of a multichannel signal generator. For such a signal generator it is essential to accurately set the amplitude and phase of the tones generated in each of the channels, thereby mitigating as much as possible the effect of an undesired relative delay and phase offset between different transmit channels. During operation it is important to accurately monitor and, if needed, correct the synchronization of the signal generation over the various channels. In many application fields it is desirable to monitor parameters indicative of relative amplitude and phase distortion (like, e.g., relative delay and phase offset) between the channels as a function of time, temperature, events like retuning (i.e. tuning to another carrier frequency and returning to the original carrier frequency), a reset or a reboot. Parameters are to be monitored with respect to the other transmit channels of the multichannel system. Further, during a system's lifetime, such monitoring information can yield interesting information for a user of the system, for example to know when it is required to perform a new calibration at system level. In the present invention an approach to achieve such monitoring is proposed wherein simple but smartly selected tones are used within the modulation bandwidth of interest instead of modulated subcarriers within an OFDM context. In the latter case, multiple closely spaced orthogonal subcarrier signals with overlapping spectra are transmitted, with each subcarrier being modulated, possibly using a different modulation scheme.

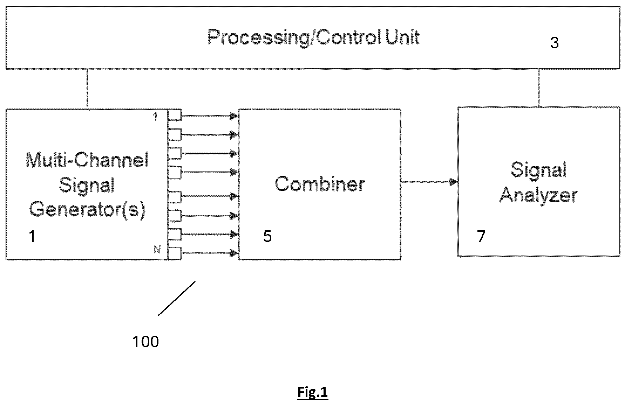

Apart from the multichannel signal generator (1) to be tested there are three essential components in the system (100) according to the invention, namely a combiner (5), a signal analyzer (7) and a block functionally referred to as a processing/control unit (3). A high-level scheme is shown in Fig.1.

The multichannel signal generator is the device under test and is adapted to generate a transmit signal in each of a plurality of transmit channels. The multichannel signal generator may comprise a plurality of individual signal generators which at a specific moment in time each can generate modulation tones in one of the transmit channels. The generated transmit signals are periodic RF modulated signals. The signals are generated based on configuration information comprising a given carrier frequency $f_c$ and modulation frequency $f_m$ (or, equivalently, the modulation period $T_m = 1/f_m$). Further also the number of frequency tones to be generated is a given configuration parameter. This number combined with the modulation frequency yields the total modulation bandwidth. In the approach according to the invention there is no modulation tone generated at the carrier frequency $f_c$. Although extension to other multiplexing techniques like time division multiplexing or code division multiplexing can be considered, the approach according to the invention primarily focusses on frequency division multiplexing.

The configuration information used to generate the transmit signals in the signal generator is provided by the processing/control unit. The processing/control unit also determines for each of the modulation tones to be generated an amplitude and phase, which are conveyed to the signal generator. As will be described in detail later in this disclosure, the amplitudes of the various tones are determined so that a combined RF signal comprising all tones generated in the various transmit channels, has a peak to average power ratio and a peak power that meets a preset condition.

The various generators in the multichannel signal generator are in preferred embodiments vector signal generators. The generators use a common trigger signal to ensure simultaneous signal generation (in the case of frequency or code division) or multichannel signal generation based on time division multiplexing. In preferred embodiments, the signal generators of the multichannel signal generator also use a common local oscillator (LO), although this is not strictly needed.

The combined RF signal is obtained in a combiner where the generated modulation tones are physically combined. The combining operation performed by the combiner can mathematically be expressed as :

$$s(t) = \sum_{k=1}^{N} A_k sin(\omega_k t + \theta_k)$$

where $N$ denotes the number of tones, $A_k$ and $\theta_k$ the amplitude and phase of tone $k$, respectively, and $\omega_k$ the absolute pulsation $2\pi f_k$. The combined signal is a multi-tone signal, which is below sometimes also referred to as a multi-sine signal.

Preferably the various signals generated in the multichannel signal generator are fed to the combiner by means of a set of well-matched cables of substantially a same length. This is preferred as in this way it is not needed, when uploading the subset of modulation tones, to account for any difference which could negatively affect the crest factor of the measured signal at the combiner output and, hence, create additional uncertainty on estimations of delay and phase.

In preferred embodiment the combiner is symmetrical, meaning that the combiner has almost identical S-parameters $S_{ci}$ where index $i$ denotes input $i$ of the combiner and c corresponds to the common output of the combiner and where $S_{ii}$ and $S_{cc}$ are small to obtain a well-matched combiner. This offers the advantage that any need is avoided to account for any difference in $S_{ci}$ and the mismatch interactions at both inputs and output of the combiner which could negatively affect the level of the crest factor of the measured signal. In advantageous embodiments the combiner is implemented as a power combiner. For example, the power combiner may be a passive, equal weighted, power combiner having a plurality of inputs to receive the signals generated in the multichannel signal generator and an output providing the combined signal. The power combiner is typically connected to output ports of the multichannel signal generator.

The signal analyzer (7) depicted in Fig.1 is the receiver. It receives the combined RF signal and measures that signal taking into account the configuration information received from the processing/control unit (cfr. infra), which at least comprises the carrier frequency, modulation frequency and the number of generated tones. In other words, the signal analyzer is provided with substantially the same configuration information as the multichannel signal generator. The processing/control unit initiates a measurement and fetches the measured signal from the signal analyzer for further processing, when the data is acquired by the signal analyzer.

A key observation to arrive at the present invention is that the receiver introduces measurement noise, which typically scales with the input reference level. As such it is important to apply a signal which has a low enough crest factor (CF) or peak-to-average power ratio (PAPR), i.e. below a predefined threshold level, to reduce the uncertainty on the figures of merit (or performance parameters) extracted from the (noisy) measurement, such as - but not limited to - the relative delay and phase offset, based on a set of modulation tones assigned to each signal generator. A person skilled in the art will readily admit that the measurement noise floor is also impacted by the resolution bandwidth which is defined by the sampling frequency used by the signal analyzer and the number of modulation periods being included in the actual measurement.

The processing/control unit can be considered as the crucial component in the method and system of the present invention. It was already mentioned that this block conveys configuration information to both the multichannel signal generator and the signal analyzer (i.e. the receiver where the combined signal is measured). The actual execution of the method of the invention is initiated by the processing/control unit generating a common trigger signal to the multichannel signal generator. This trigger signal initiates the signal generation in the various generators of the multichannel signal generator taking into account the conveyed configuration information. As already mentioned, the generated signals in the respective transmit channels are periodic signals. At the level of the multichannel signal generator, the underlying hardware allows the processing/control unit to initiate at a specific moment in time the simultaneous generation of the signals which were uploaded to each channel. This is typically realized using a common hardware trigger signal, where e.g., the signal generation is initiated at (or relative to) the rising edge of a digital (e.g., Transistor-Transistor Logic (TTL)) trigger signal, possibly in combination with other means (such as a Trigger Clock (NI-TClk) in the case of PXI™ modules manufactured by National Instruments which supports improved synchronization). Alternatives exist in which a common time signal (e.g. a Pulse Per Second (PPS) signal) and a timekeeper (typically a counter) are shared, and the processing/control unit instructs all channels to initiate the signal generation at a defined time stamp (e.g., at a defined counter value). The signal generation lasts until it is aborted by the processing/control unit.

The processing/control unit further also launches a measurement trigger signal to the signal analyzer, which initiates a single measurement according to the settings previously conveyed to the signal analyzer. For each measurement to be made a measurement trigger signal is fired. In some embodiments measurement trigger signals are generated at regular times, e.g. every 30 seconds, or 1 minute or 3 minutes, to collect new measurement signals. In typical embodiments a software trigger signal is used as measurement trigger signal. This implies the processing/control unit instructs the signal analyzer to initiate a measurement as soon as the signal analyzer is ready to do so. The time between sending and/or receiving this instruction and the actual initiation of the measurement is undefined and typically changes from acquisition to acquisition. In other embodiments, however, it is possible to make sure the measurement is initiated at a well-defined time by using a hardware trigger signal, where, e.g., the measurement is initiated at the rising edge of a digital (e.g., TTL) trigger signal. The result from each measurement, i.e. the measured signal, is downloaded to the processing/control unit for further processing, as will be detailed below.

In some embodiments, in the case of e.g. periodic modulated signals as in the present invention, it is possible to make sure that the measurement is initiated at a fixed time relative to the start of a modulation period by e.g. using a marker, which can be used as a hardware trigger signal as explained above. As such it is possible in such embodiments to eliminate the unknown delay at the receiver side as would be the case when using a software trigger signal for the signal analyzer.

An important task of the processing/control unit is the determination of an amplitude and phase for the generated modulation tones to synthesize the periodic modulated signal. The goal thereby is to keep the crest factor (i.e. the peak to root mean square (RMS) value) or the peak-to-average-power ratio (PAPR) of the resulting combined signal comprising all generated tones below a predefined threshold, preferably even as small as possible. Note that ideal constant-amplitude modulated signals have a crest factor of 1 (i.e., a PAPR of 0 dB).

A person skilled in the art will readily admit there are in the state of the art many techniques available to reduce the crest factor factor (CF) or peak-to-average power ratio (PAPR) of a multi-tone signal below a predefined threshold value. In some embodiments a value for the crest factor (CF) or peak-to-average power ratio (PAPR) is determined using one of the well-known algorithms briefly discussed below. Such more basic solutions in general have a known crest factor depending on the number of tones. In case this does not yield a low enough value (below the given threshold level) one can in certain embodiments make use of more advanced algorithms as discussed below to further reduce and optimize the value of the crest factor of peak-to-average ratio. Some of these advanced (iterative) algorithms allow specifying a target crest factor upfront.

In advantageous embodiment of this invention equal-amplitude multi-tone signals (also sometimes referred to as multi-sine signals hereinafter) are used having a well-chosen phase relationship to reduce the crest factor (CF) to a value below the set threshold CF level, or as low as possible. Several existing algorithms can be used to implement this. The following table gives an overview of the phase values applied in the algorithms proposed by Schroeder, Newman, Kitayoshi and Narahashi, respectively, as summarized in the paper 'Analysis and Design of Multi-Tone Signal Generation Algorithms for Reducing Crest Factor' (Y.Shibasaki, IEEE ATS, November 2020) :

| Newman Phase | $\theta_k = \dfrac{\pi}{N}(k-1)^2$ |
|---|---|
| Kitayoshi Phase | $\theta_k = \dfrac{\pi}{N}k(k+1)$ |
| Schroeder Phase | $\theta_k = -\dfrac{\pi}{N}k(k-1)$ |
| Narahashi Phase | $\theta_k = \dfrac{\pi}{N-1}(k-1)(k-2)$ |

where *k* is an index denoting the tone being used and *N* the number of tones.

In some embodiments modulation tones may be given different amplitudes to obtain a crest factor below the given threshold value.

More advanced techniques to further reduce the crest factor are described in the literature, for example in the paper 'Optimization of the Crest Factor for Complex-Valued Multisine Signals' (B. Seppentö, Radio Engineering Journal, vol.32, no.2, June 2023, pp.264-272). These techniques can be applied in the context of this invention. The paper presents an approach modified to optimize the crest factor for complex-valued multi-sine signals. A nonlinear optimization method is used wherein the real and imaginary parts can also be optimized for obtaining a low CF and PAPR. Furthermore, extensions of the real-valued multi-sine CF optimization methods are presented for complex-valued signals having an equi-flat amplitude spectra. One option is clipping the absolute value of samples in the time-domain while keeping the phase information. Alternatively, the algorithm can be executed separately on the real and imaginary parts of the complex signal.

As an alternative implementation, signals derived from constant-amplitude-zero-auto-correlation (CAZAC) sequences such as Zadoff-Chu (ZC) sequences can be used, i.e., a complex-valued sequence which, when applied to a signal, gives rise to a new signal of constant amplitude. When cyclically shifted versions of a Zadoff-Chu sequence are imposed upon a signal, the resulting set of signals detected at the receiver are uncorrelated with one another.

Once the combined multi-tone signal is synthesized, the processing/control unit needs to assign the individual tones with their amplitude and phase as determined, to the different signal generators of the multichannel signal generator. Possibly known imperfections of both the various generators and the signal analyzer (receiver) are thereby taken into consideration. Imperfections may include the generation of images (due to IQ impairments) and/or local oscillator (LO) leakage.

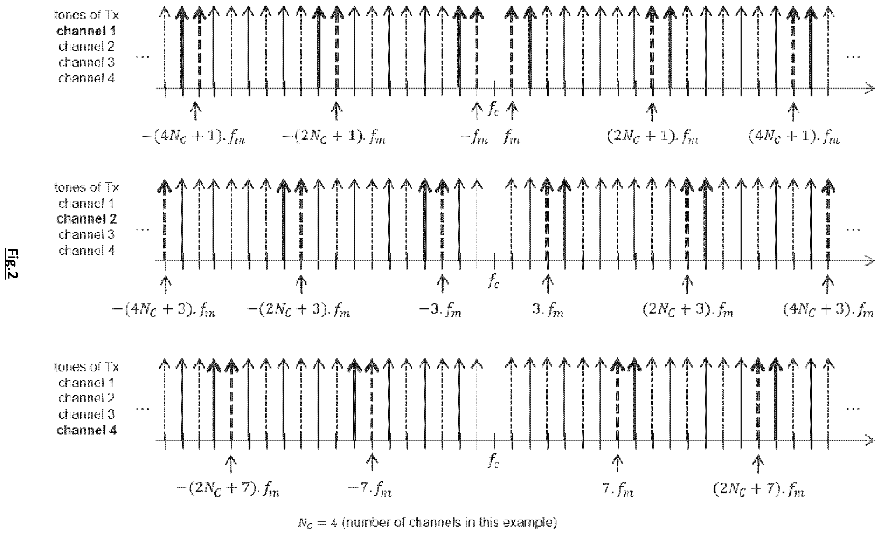

It is however possible to avoid a possible negative impact of the above-mentioned imperfections on an accurate extraction of relative delay and phase offset. One approach is illustrated in Fig.2. An example is considered with a four-channel generator. The skilled person readily understands this is merely an example and the invention is in no way limited thereto. Extension of the example of Fig.2 to any number of channels is straightforward.

Fig.2 illustrates that no signal is applied at the carrier frequency $f_c$ (corresponding to DC at baseband). In the example of Fig.2, the (frequencies of the) tones assigned to each transmit channel are symmetrical with respect to the carrier frequency such that image tones, which are possibly created as part of the non-perfect signal generation and measurement, are superimposed to tones assigned to the same transmit channel and as such do not impact the signals generated by another transmit channel.

In other embodiments according to the invention there may be no symmetry of the modulation tones relative to $f_c$. In some embodiments there may be only tones at one side of $f_c$, e.g., only at frequences greater than the carrier frequency.

In advantageous embodiments one or more of the tones assigned to the transmit channels are in fact sets of two-tones, i.e. pairs of two adjacent tones. Such two-tones are capable of unambiguously identifying the delay relative to the reference measurement for each of the transmit channels, the delay having a value anywhere between $-T_m/2$ and $+T_m/2$, with $T_m$ denoting the modulation period. In Fig.2 each pair of two-tones is illustrated with one tone indicated in solid line and the other tone in dashed line.

In embodiments where two-tone signals are used, anomalies of the relative delay in the range between $-T_m/2$ and $+T_m/2$, due to unexpected (incorrect) operation of the multi-channel signal generator, can be detected. In further embodiments with two-tone signals the combiner may be substantially symmetrical and the cables between the multi-channel generator and the combiner inputs have a substantially equal length (meaning a length that does not give rise to a meaningful deterioration of the crest factor).

In alternative embodiments, instead of sets of two-tones, sets of single tones may be assigned to a transmit channel. In some embodiments sets of more than two tones may be used. This may allow for a further optimization, by further reducing or minimizing the crest factor of each signal being generated by the individual signal generators. This may be particularly useful when the noise at the transmitter side is found to be dominant.

Independent of the distribution of the modulation tones between the different signal generators of the multi-channel signal generator, the combined signal allows correctly assessing any relative delay between $-T_m/2$ and $+T_m/2$, relative to another measurement of the combined signal.

In embodiments where the combiner is not symmetrical and/or cables of non-identical length are used, possibly with an impedance mismatch, this can be taken into account by the processing/control unit when uploading the signals to each transmit channel to have an acceptable crest factor at the combiner output.

In some embodiments, which focus on multichannel synchronization assessment and not on correction, it may not be needed to deal with and correct for imperfections of the combiner and/or non-perfectly-equal-length cables and/or mismatch effects, provided that the imperfections do not lead to a meaningful deterioration of the crest factor. An example use case is the study of the variation of the relative delay and phase offset relative to an initial measurement, e.g., as function of time and/or temperature and/or as function of events such as a retune (i.e., moving to another carrier frequency and returning to the original carrier frequency), software reset and/or hardware reset. In the latter case it is assumed that the combiner, cables and/or signal analyzer in the measurement set-up (beyond the multichannel transmit signal generators) remain sufficiently stable or only slightly vary within the considered total modulation bandwidth resulting in almost equal impact on the measured tones and as such not impacting the relative performance parameters. Other use cases, e.g., in support of correction, may require to properly characterize the combiner and/or signal analyzer, their mutual interactions and/or the interaction with the signal generators.

The processing/control unit further takes care of distributing the modulation tones to be generated over the various transmit channels and uploading the baseband signal corresponding to the various tones to their respective transmit channels. To allow simple processing in preferred embodiments an equidistant frequency grid relative to the carrier frequency is used. The distribution of the tones can be based on various criteria, such as dealing with known artifacts like the generation of images in the case of IQ imbalance. Another criterion is the minimization of the crest factor of the signal being uploaded to and generated by each transmit channel.

In some embodiments one or more tones can have their amplitude set to zero, i.e. the tone is not generated and is hence not present in the combined signal. Doing so may be advantageous as it is a simple way to avoid the negative impact of possible images. However, it may be expected to negatively impact the crest factor of the combined signal. Hence, setting amplitudes to zero may only be acceptable if the crest factor remains in a range where a specified threshold value is not exceeded.

On instruction of the processing/control unit, the signal analyzer performs a measurement from which an input reference level is determined. When defining the signal to be generated by the multichannel signal generator as part of an initial measurement, one can adjust the (absolute) peak or average power of the generated combined signal (whereby adjustment is simultaneously applied to all transmit channels) to allow using an input reference level where the noise floor properly scales with the input reference level. In practice, the input reference level is set as part of the reference measurement and remains unchanged afterwards. This input reference level plays an important role to reduce the uncertainty on the measurements.

The measurement results are downloaded from the signal analyzer to the processing/control unit where the input reference level is computed and stored. This can be an iterative process with the goal to use the full-scale range while avoiding any distortion, e.g. due to an overrange or clipping (whereby the final input reference level selected must be such that one is close to full-scale range without distortion).

In a most general embodiment, the hardware trigger signal and the optional common local oscillator which are shared between the various generators of the multichannel signal generator, are not shared with the signal analyzer. In such case, one first has to extract the unknown delay and phase offset introduced by successive measurements of the combined signal. This can be achieved by having the processing/control unit adapted for performing an estimation, which can be based on solving a nonlinear minimization problem with respect to the relative delay and phase offset. Appropriate starting values can be found, e.g., based on the auto- and cross-correlation properties of signals which also result in small crest factors. The estimated relative delay and phase offset is applied to all modulation tones of the actual measurement before executing the subsequent method steps. This step can be skipped in case the single receiver uses the hardware trigger and (optional) common LO used by the set of signal generators. In some embodiments, a different hardware trigger signal can be used for signal generation and measurement, as long as these triggers have a fixed relationship in time.

As a result of the processing in the processing/control unit the delay and phase offset can be extracted for each transmit channel relative to the reference measurement. This processing is basically performed as follows. First, the combined signal is aligned with respect to the combined reference signal to deal with the (default) situation of no hardware trigger and common LO being shared between the signal generators of the multichannel signal generator and the signal analyzer. Next, the individual signals generated by (or, in other words, the tones assigned to) each transmit channel are extracted from the aligned combined measurement result and compared against the reference measurement of the tones assigned to each transmit channel. This allows extracting for each transmit channel delay and phase offset information relative to the reference measurement.

An example of the processing is now given. Assume a reference signal in the frequency domain, i.e., $X_i(k. f_m) \in \mathbb{C}$ with $k. f_m$ relative to carrier frequency $f_c$ where $i$ corresponds to the transmit channel and $k = -M .. +M$, with $M$ corresponding to the number of single-sideband tones. A unique subset of $k = -M .. +M$ is assumed to be assigned to each transmit channel as in Fig.2. The simplified situation of two transmit channels with reference signals $X_1(k. f_m)$ and $X_2(k. f_m)$ is explained. First, a situation is considered where a common delay $\tau$ and phase offset $\phi$ is applied to both transmit channels. Then the combined signal equals $\{X_1(k. f_m) + X_2(k. f_m)\}.e^{j(2\pi k.f_m.\tau+\phi)}$ and the estimator in the processing/control unit will correctly retrieve the delay $\tau$ and phase offset $\phi$ relative to $\{X_1(k. f_m) + X_2(k. f_m)\}$. In practice, this delay $\tau$ and phase offset $\phi$ is the consequence of not using a common hardware trigger and local oscillator between the multi-channel signal generator and the signal analyzer. After alignment of the combined signal, based on the unique subset of $k = -M .. +M$ being assigned to each transmit channel, one can correctly retrieve the reference signals $X_1(k. f_m)$ and $X_2(k. f_m)$.

Now a second situation is considered where $X_1(k. f_m)$ remains unchanged and a delay $\Delta\tau$ and phase offset $\Delta\phi$ is applied to $X_2(k. f_m)$. On top of that a common delay $\tau$ and phase offset $\phi$ is applied to the combined signal to end up with signal $X(k. f_m)$

$$X(k. f_m) = \left\{X_1(k. f_m) + X_2(k. f_m). e^{j(2\pi k.f_m.\Delta\tau+\Delta\phi)}\right\} e^{j(2\pi k.f_m.\tau+\phi)}$$

In a first step the combined signal $X(k. f_m)$ is aligned against the combined reference signal $\{X_1(k. f_m) + X_2(k. f_m)\}$ as

$$X(k. f_m) = \{X_1'(k. f_m) + X_2'(k. f_m)\}. e^{j(2\pi k.f_m.\tau'+\phi')}$$

where $X_1'(k. f_m) \cong X_1(k. f_m). e^{-j(2\pi k.f_m.\frac{\Delta\tau}{2}+\frac{\Delta\phi}{2})}$ and $X_2'(k. f_m) \cong X_2(k. f_m). e^{j(2\pi k.f_m.\frac{\Delta\tau}{2}+\frac{\Delta\phi}{2})}$. This implies that $\tau' = \tau + \frac{\Delta\tau}{2}$ and $\phi' = \phi + \frac{\Delta\phi}{2}$. In a second step $X_1'(k. f_m)$ is aligned with respect to $X_1(k. f_m)$ and $X_2'(k. f_m)$ with respect to $X_2(k. f_m)$, resulting in a relative delay of $-\frac{\Delta\tau}{2}$ and $+\frac{\Delta\tau}{2}$, respectively, and phase offset of $-\frac{\Delta\phi}{2}$ and $+\frac{\Delta\phi}{2}$, respectively. This correctly shows an overall relative delay of $\Delta\tau$ of transmit channel 2 with respect to transmit channel 1 and a relative phase offset of $\Delta\phi$. The explanation above can be generalized to deal with $N$ channels using $\sum_{i=1}^{N} X_i(k. f_m)$ instead of $X_1(k. f_m) + X_2(k. f_m)$.

For the most general situation, i.e., the hardware trigger signal and the optional common local oscillator which are shared between the various generators of the multichannel signal generator, is/are not shared with the signal analyzer, the relative delay and phase offset, averaged over all signal generators with respect to the reference signal generated by each signal generator, may be included as part of the relative delay and phase offset of the combined signal. The latter refers to a common drift of all transmit channels. However, this has no negative impact on (the estimation of the variation of) the relative delay and phase offset of one transmit channel to another transmit channel. From a multichannel synchronization point of view, only a transmit-channel-by-channel variation must be considered.

Minimizing the uncertainty on the estimated relative delay and phase offset by minimizing the receiver measurement noise for a given combined signal is one of the key features of this invention. This is achieved by using a combined signal exhibiting a small crest factor, which allows choosing the smallest possible input reference level. By assessing the relationship of the measurement noise floor compared to the amplitude of the actual modulation tones and

## EP 4 718 750 A1

the resulting uncertainty on the estimated relative delay and phase offset, e.g., by means of simulations, the proposed method also allows adding uncertainty bounds and distinguishing between observed variations due to measurement noise and true variations, the latter referring to the relative delay and phase offset.

Simulations confirm that improving the signal-to-noise ratio (SNR) by 6 dB, e.g. by reducing the crest factor of the periodic modulated (combined) signal by 6 dB, the uncertainty on both estimated relative delay and phase offset is reduced by 50%.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### Claims

1. Method for performance assessment of a multichannel signal generator comprising a plurality of transmit channels, the method comprising:

   - conveying to said multichannel signal generator configuration information comprising at least a carrier frequency, a modulation frequency and a number of tones to be generated,
   - determining for each of said tones an amplitude and phase,
   - distributing said tones with said determined amplitude and phase over said transmit channels,
   - generating, in response to receiving a generation trigger signal and based on said configuration information, in each transmit channel a periodic modulated signal comprising said tones distributed to the respective transmit channel,
   - combining the generated periodic modulated signals in a combined signal,

   **characterised in that** said amplitudes and phases are determined so that said combined signal has a crest factor or peak-to-average power ratio below a given threshold level,

   - measuring said combined signal in response to receiving a measurement trigger signal, thereby taking into account said configuration information,
   - aligning said combined signal relative to a reference combined signal,
   - extracting from said aligned combined signal individual tones corresponding to said tones generated in the respective transmit channels,
   - determining a relative delay and/or a phase offset for at least two transmit channels by comparing the extracted individual tones with corresponding individual tones extracted from said reference combined signal, so that information can be obtained on a difference in relative delay and/or phase offset between said at least two transmit channels.

2. Method for performance assessment as in claim 1, comprising a step of performing a reference measurement to measure said reference combined signal and to determine said input reference level from the measured reference combined signal.

3. Method for performance assessment as in claim 2, wherein said reference combined signal corresponds to a full-scale range corresponding to said input reference level.

4. Method for performance assessment as in any of the previous claims, wherein said tones are sets of two-tones.

5. Method for performance assessment as in any of claims 1 to 4, wherein said tones are sets of more than two tones.

6. Method for performance assessment as in any of the previous claims, wherein one or more of said tones are set to zero.

7. Method for performance assessment as in any of the previous claims, wherein said generated tones have equal amplitude.

8. Method for performance assessment as in any of the previous claims, wherein said amplitudes and phases are determined so that a minimum value is obtained for said crest factor or peak-to-average power ratio of said combined signal.

9. Method for performance assessment as in any of the previous claims, wherein said crest factor or peak-to-average power ratio is obtained by applying a nonlinear optimization algorithm.

10. System (100) for assessing performance of a multichannel signal generator comprising

- a multichannel signal generator (1) comprising a plurality of transmit channels,
- a processing/control unit (3) adapted for conveying to said multichannel signal generator configuration information comprising at least a carrier frequency, a modulation frequency and a number of tones to be generated, for determining for each of said tones an amplitude and phase, and for distributing said tones having said determined amplitude and phase over said plurality of transmit channels,

    whereby said multichannel signal generator is arranged for generating, in response to receiving a generation trigger signal from said processing/control unit and based on said configuration information, in each transmit channel a periodic modulated signal comprising said tones assigned to the respective transmit channel, the system further comprising

- a combiner (5) configured to combine the generated periodic modulated signals in a combined signal,
- a signal analyzer (7) for measuring said combined signal in response to receiving a measurement trigger signal from said processor unit/controller, thereby taking into account said configuration information, wherein said processor unit/controller is configured to determine said amplitudes and phases so that said combined signal has a crest factor or peak-to-average power ratio below a given threshold level and to align said combined signal with a reference combined signal, to extract from said aligned combined signal individual tones corresponding to said tones generated in the respective transmit channels, and to determine a relative delay and/or a phase offset for at least two transmit channels by comparing the extracted individual tones with corresponding individual tones extracted from said reference combined signal, so that information can be obtained on a difference in relative delay and/or phase offset between said at least two transmit channels.

11. System as in claim 10, wherein said combiner is a power combiner.

12. System as in claim 10 or 11, wherein said multichannel signal generator comprises a plurality of vector signal generators.

13. System as in claim 12, wherein vector signal generators are arranged to receive a common local oscillator signal.

14. System as in any of claims 10 to 13, wherein said multichannel signal generator is connected to said combiner via cables of substantially equal length.

15. System as in any of claims 10 to 14, wherein said combiner is substantially symmetrical.

Processing/Control Unit 3

Multi-Channel Signal Generator(s) 1

Combiner 5

Signal Analyzer 7

100

**Fig.1**

**Fig.2**

Europäisches
Patentamt
European
Patent Office
Office européen
des brevets

# EUROPEAN SEARCH REPORT

**Application Number**

EP 24 20 3205

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | US 9 432 133 B2 (KEYSIGHT TECHNOLOGIES INC [US]) 30 August 2016 (2016-08-30) <br> * column 5, line 4 - line 33 * <br> * column 9, line 4 - line 55 * <br> ----- | 1-15 | INV. <br> H04B17/10 |
| A | GEORGE KIRAN ET AL: "Modular test RF instrumentation and measurement for a hybrid computing digital wideband receiver", <br> 2014 IEEE INTERNATIONAL INSTRUMENTATION AND MEASUREMENT TECHNOLOGY CONFERENCE (I2MTC) PROCEEDINGS, IEEE, <br> 12 May 2014 (2014-05-12), pages 352-356, <br> XP032620814, <br> DOI: 10.1109/I2MTC.2014.6860766 <br> [retrieved on 2014-07-18] <br> * section I; <br> figure 1 * <br> * section II; <br> figure 2 * <br> ----- | 1-15 | |
| A | US 7 389 193 B2 (SAMSUNG ELECTRONICS CO LTD [KR]) 17 June 2008 (2008-06-17) <br> * column 4, line 1 - line 61 * <br> ----- | 1-15 | **TECHNICAL FIELDS SEARCHED (IPC)** <br><br> H04B <br> G01R |

The present search report has been drawn up for all claims

| Place of search | Date of completion of the search | Examiner |
|---|---|---|
| The Hague | 6 March 2025 | Riposati, Benedetto |

EPO FORM 1503 03.82 (P04C01)

## ANNEX TO THE EUROPEAN SEARCH REPORT
## ON EUROPEAN PATENT APPLICATION NO.

EP 24 20 3205

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2025

| Patent document cited in search report | | Publication date | Patent family member(s) | | Publication date |
|---|---|---|---|---|---|
| US 9432133 | B2 | 30-08-2016 | CN | 105847210 A | 10-08-2016 |
| | | | US | 2016226605 A1 | 04-08-2016 |
| US 7389193 | B2 | 17-06-2008 | KR | 20070017612 A | 13-02-2007 |
| | | | US | 2007037519 A1 | 15-02-2007 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9432133 B2

**Non-patent literature cited in the description**

- Analysis and Design of Multi-Tone Signal Generation Algorithms for Reducing Crest Factor. **Y.SHIBASA-KI**. IEEE ATS. November 2020

- **B. SEPPENTÖ**. Optimization of the Crest Factor for Complex-Valued Multisine Signals. *Radio Engineering Journal*, June 2023, vol. 32 (2), 264-272